# DEMANDE DE BREVET EUROPEEN

(11) **EP 3 629 380 A1**
(43) Date de publication de la demande: **01.04.2020**
(21) Numéro de dépôt: 19199921.8
(22) Date de dépôt: 26.09.2019
(51) Int. Cl.: H01L 29/40, H01L 21/329, H01L 29/861

(54) **STRUCTURE DE DIODE**

(30) Priorité: 28.09.2018 FR 1858933
(71) Demandeur: STMicroelectronics (Tours) SAS, 37100 Tours (FR)
(72) Inventeur: LANOIS, Frederic, 37100 TOURS (FR)
(74) Mandataire: Cabinet Beaumont

(57) **Abrégé**

Structure comprenant, dans une tranchée (22) d'un substrat (20), une première région conductrice (302) séparée du substrat d'une première distance (d) inférieure à environ 10 nm ; et une deuxième région conductrice (306) s'étendant plus profondément que la première région.

## Description

### Domaine technique

La présente demande concerne de façon générale le domaine des circuits électroniques, et plus particulièrement une structure de diode.

### Technique antérieure

Dans certaines applications, telles que par exemple des applications d'électronique de puissance, on souhaite disposer de diodes permettant de laisser passer en sens direct des courants de valeurs élevées, par exemple de plus de 1 A, voire de plus de 100 A, avec une chute de tension la plus faible possible aux bornes de la diode. On souhaite de plus que la diode laisse passer un courant de fuite le plus faible possible lorsqu'elle est polarisée en inverse. On souhaite en outre que la diode soit capable de bloquer le passage du courant pour des valeurs élevées de tension en inverse, par exemple de plus de 10 V, voire de plus de 100 V.

### Résumé de l'invention

Un mode de réalisation prévoit de pallier tout ou partie des inconvénients des structures de diode connues.

Un mode de réalisation prévoit une structure permettant d'obtenir une diode dont la tension maximale en inverse, ou tension d'avalanche, la chute de tension en direct et/ou le courant de fuite sont améliorés par rapport aux diodes connues.

Ainsi, un mode de réalisation prévoit une structure comprenant, dans une tranchée d'un substrat, une première région conductrice séparée du substrat d'une première distance inférieure à environ 10 nm ; et une deuxième région conductrice s'étendant plus profondément que la première région, les première et deuxième régions formant une région commune.

Selon un mode de réalisation, la deuxième région est séparée du substrat d'une deuxième distance supérieure à la première distance.

Selon un mode de réalisation, la première région est séparée du substrat par une première couche diélectrique et la deuxième région est séparée du substrat par une deuxième couche diélectrique.

Selon un mode de réalisation, le substrat est semiconducteur.

Selon un mode de réalisation, la structure comprend une portion de couche conductrice recouvrant le substrat et la tranchée, ladite portion étant connectée électriquement au substrat et aux première et deuxième régions.

Selon un mode de réalisation, ladite portion est en contact avec le substrat ou séparée du substrat de moins de 300 nm.

Un mode de réalisation prévoit une diode comprenant une ou plusieurs structures définies ci-dessus.

Selon un mode de réalisation, la diode est définie par un ou plusieurs transistors dont au moins une région de canal s'étend entre deux des tranchées, les premières régions définissant les grilles des transistors.

Selon un mode de réalisation, la diode comprend une région de prise de contact reliant électriquement la région de canal à la couche conductrice.

Selon un mode de réalisation, les premières régions sont en un semiconducteur dopé, la région de canal et les premières régions étant dopées de types de conductivité opposés.

Selon un mode de réalisation, la diode comprend une région de drain s'étendant sous la région de canal entre les deux tranchées, et de préférence sous les tranchées.

Selon un mode de réalisation, la région de drain est moins fortement dopée que la région de canal.

Un mode de réalisation prévoit un procédé de fabrication d'une structure définie ci-dessus.

Selon un mode de réalisation, le procédé comprend la formation de la deuxième couche diélectrique sur les parois et le fond de la tranchée, et le retrait d'une partie de la deuxième couche diélectrique située à l'emplacement de la future première région.

Selon un mode de réalisation, le procédé comprend une étape d'oxydation thermique de parois de la tranchée délimitant l'emplacement de la future première région.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique en coupe illustrant un mode de réalisation d'une diode ; et
les figures 2A à 2F illustrent des étapes d'un mode de mise en oeuvre d'un procédé de fabrication de la diode de la figure 1.

### Description des modes de réalisation

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation de l'élément concerné dans les figures, étant entendu que, dans la pratique, les dispositifs décrits peuvent être orientés différemment. Sauf précision contraire, les expressions "environ", "approximativement", "sensiblement", et "de l'ordre de" signifient à 10 % près, de préférence à 5 % près.

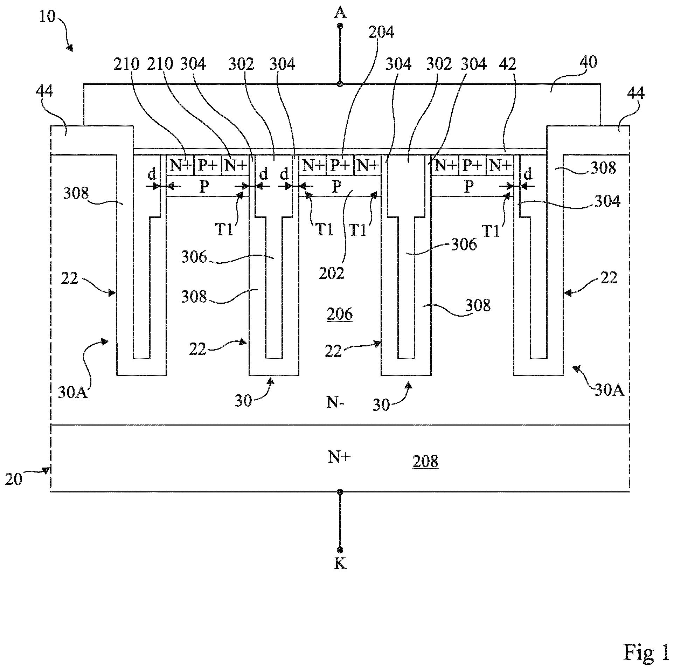

La figure 1 est une vue schématique en coupe illustrant un mode de réalisation d'une diode 10.

La diode 10 comprend un substrat 20, par exemple en un semiconducteur tel que le silicium. La diode comprend une borne de cathode K, par exemple connectée électriquement à une face inférieure du substrat, et une borne d'anode A. La diode 10 comprend des tranchées 22. Les tranchées 22 s'étendent dans le substrat 20 à partir de la face supérieure du substrat. Les tranchées 22 sont par exemple parallèles entre elles. Les tranchées 22 sont par exemple régulièrement espacées. A titre de variante, les tranchées 22 sont en forme d'anneaux concentriques.

La diode comprend des structures 30A, décrites ci-après, situées chacune dans une tranchée 22. La diode comprend par exemple deux structures 30A de part et d'autre de la diode. De préférence, entre les structures 30A, la diode comprend en outre une ou plusieurs structures 30.

Chaque structure 30 comprend, dans la tranchée 22 concernée, une région électriquement conductrice 302. La région conductrice 302 est située dans une partie supérieure de la tranchée 22. La région 302 est disjointe des parois de la tranchée 22. La région 302 est par exemple séparée des parois par des couches diélectriques 304 disposées de part et d'autre de la région 302. On comprendra que les couches 304 peuvent être des portions d'une même couche diélectrique. La région 302 et les parois sont séparées d'une distance d faible, de préférence inférieure à 10 nm, par exemple inférieure à 7 nm.

Chaque structure comprend en outre une région électriquement conductrice 306 s'étendant dans la tranchée plus bas que la région 302. Dans l'exemple illustré en figure 1, la région 306 s'étend à partir de la région 302. En d'autres termes, les régions 302 et 306 sont d'une seule pièce, c'est-à-dire forment une région commune. La région 306 est par exemple située plus loin des parois de la tranchée que la région 302. La région 302 est par exemple séparée du substrat 10 par une couche diélectrique 308 recouvrant les parois et le fond de la tranchée 22. L'épaisseur de la couche 308 est par exemple supérieure à environ 100 nm, de préférence comprise entre 250 nm et 1000 nm.

Les structures 30A reprennent les mêmes éléments que les structures 30. Toutefois, l'important est que la distance faible d mentionnée ci-dessus soit absente du côté extérieur de la diode. A titre d'exemple, la couche 308 se prolonge alors entre la région 302 et la paroi de la tranchée du côté extérieur de la diode. La couche 308 peut rejoindre une couche isolante 44 recouvrant le substrat sur la périphérie de la diode.

A titre d'exemple, les régions 302 et 306 sont en silicium polycristallin dopé, et les couches 304 et 308 sont en oxyde de silicium.

Comme ceci est exposé ci-après dans le cas particulier de la diode 10, les régions 302 et 306 ainsi obtenues permettent, lorsque des potentiels leurs sont appliqués, d'exercer des influences électrostatiques différentes sur les parties du substrat en contact avec les couches 304 et 308. En particulier, plus la région 302 est proche du substrat, plus l'influence électrostatique sur la partie du substrat en contact avec la couche 304 est forte.

On peut alors former un transistor T1 dans la partie du substrat en contact de chaque couche 304, la région 302 considérée formant la grille du transistor. A titre d'exemple, les transistors T1 sont à canal N. Chaque transistor comprend une région de canal 202 (P) dopée de type P. A titre d'exemple, chaque région de canal 202 s'étend entre deux tranchées 22 voisines et est ainsi commune à deux transistors T1 voisins. Chaque région de canal commune à deux transistors a par exemple une partie centrale surmontée d'une prise de contact 204 (P+). Les prises de contact 204 sont plus fortement dopées de type P que les régions de canal 202.

Chaque transistor comprend en outre une région de drain 206 (N-) située sous la région de canal. A titre d'exemple, chaque région de drain 206 s'étend entre deux tranchées 22 voisines et est commune aux transistors T1 voisins. Les régions de drain 206 peuvent se prolonger sous les tranchées, et les régions de drain peuvent alors se rejoindre sous les tranchées. Les régions de drain sont par exemple sur et en contact avec une région de prise de contact 208 (N+) s'étendant en partie inférieure du substrat. La région 208 est plus fortement dopée que les régions de drain 206. La région 208 est reliée électriquement à la borne K.

Chaque transistor comprend en outre une région de source 210 (N+), de préférence située contre la couche 304. La région de source 210 est par exemple plus fortement dopée de type N que la région de drain 206.

Lorsqu'un transistor tel que décrit ci-dessus est à l'état passant, un canal conducteur vertical situé contre la couche 304 dans la région de canal 202 relie la région de source 210 à la région de drain 206. La longueur de canal du transistor correspond ainsi à l'épaisseur de la région de canal 202. Les énergies d'implantation de la région de canal 202 et de la région de source 210 sont choisies pour obtenir la longueur de canal souhaitée. A titre d'exemple, l'épaisseur de la région 202 est comprise entre 150 nm et 800 nm.

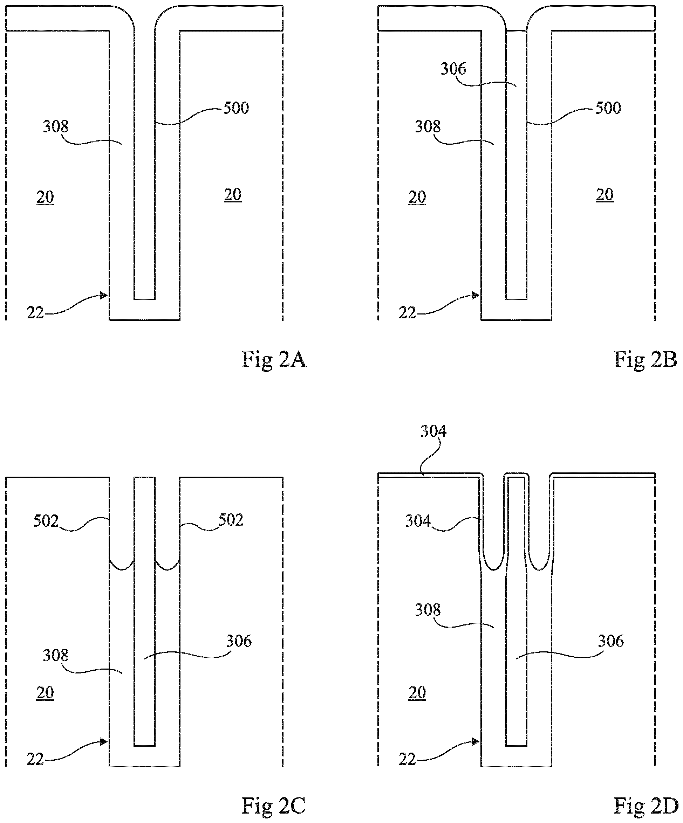

Dans la diode 10, les régions de grille 302, les régions de source 210, et les régions de prise de contact 204 des transistors T1 sont de préférence reliées électriquement à la borne d'anode A. Ceci permet aux transistors de définir la diode 10. Pour cela, à titre d'exemple, une couche conductrice 40 recouvre le substrat 20 et les tranchées 22. La couche 40 est par exemple en aluminium, aluminium-cuivre ou aluminium-silicium-cuivre. La couche 40 peut reposer sur une couche conductrice d'interface 42. Les régions 302 s'étendent dans les tranchées à partir de la couche 40 ou de l'éventuelle couche d'interface 42. La couche 42 est par exemple destinée à faciliter la formation de contacts électriques entre la couche 40 et les régions 302, 204, 210, et éventuellement la région 306 (procédé des figures 2A à 2F ci-dessous). La couche 42 peut être en un siliciure ou peut-être une couche métallique, par exemple en titane. La couche 42 peut aussi comprendre une couche de siliciure et une couche métallique, la couche métallique recouvrant la couche de siliciure et étant par exemple en titane. Le siliciure forme alors les contacts électriques, tandis que la couche métallique permet l'adhérence de la couche 40. La couche 42 peut être obtenue au moins en partie par un procédé de siliciuration auto-alignée, et le siliciure est alors discontinu et ne recouvre pas les parties supérieures de la couche 304. L'épaisseur de la couche 42 est de préférence inférieure à 300 nm, par exemple inférieure à 100 nm.

Du fait que les régions 302 et les régions de canal 202 sont séparées de la distance faible d susmentionnée, on peut choisir le niveau de dopage des régions de canal 202, et le type et le niveau de dopage des régions 302, en sorte d'obtenir pour la diode une densité de courant de saturation à 25°C par exemple comprise entre 1 nA/mm² et 1 mA/mm². De préférence, le niveau de dopage des régions 202 est compris entre 2.10¹⁶ et 10¹⁸ atomes/cm³. Pour obtenir cette densité de courant de saturation, les régions 302 sont fortement dopées du type N, par exemple à plus de 5.10¹⁸ atomes/cm³, ou plus généralement fortement dopées du type de conductivité opposé à celui des régions de canal 202. La densité de courant de saturation est ici déterminée par : a) mesure de deux points ou plus de la caractéristique densité de courant-tension de la diode polarisée en direct par une tension supérieure à 0,1 V ; puis b) obtention d'une fonction exponentielle de la tension, cette fonction passant par les deux points ou étant la plus proche des points s'ils sont plus de deux. La densité de courant de saturation est alors la valeur de la fonction exponentielle pour une tension nulle. Au cours de l'étape a), la valeur de tension de chaque point de la caractéristique est mesurée de sorte qu'elle n'inclut sensiblement pas, par exemple à 1 mV près, de chutes de tensions dans des résistances parasites d'accès à la diode. La densité de courant de chaque point correspond à une valeur de courant traversant la diode divisée par la surface comprise entre les tranchées en vue de dessus. Au cours de l'étape b), la fonction exponentielle est déterminée de préférence en minimisant la somme des carrés des différences entre les logarithmes des densités de courant mesurées et ceux de la fonction exponentielle.

Lorsque la diode est polarisée en inverse, l'influence électrostatique due aux régions 306 à travers la couche 308 permet de limiter le champ électrique (c'est-à-dire de réduire ce champ par rapport à ce qu'il serait s'il n'y avait pas les régions 306 et la couche 308) dans les régions de canal et dans les régions de drain. Ceci limite le courant de fuite dans la diode. En outre, ceci permet d'augmenter la tension d'avalanche à niveau de dopage donné des régions de drain et/ou d'augmenter le niveau de dopage des régions de drain à tension d'avalanche donnée. Un avantage d'augmenter le niveau de dopage des régions de drain est que la conductivité électrique de la diode est d'autant plus grande que ce niveau de dopage est élevé, et on limite ainsi la chute de tension dans la diode lorsqu'un courant circule en sens direct.

A titre d'exemple, les régions de drain ont un niveau de dopage compris entre 3.10¹⁵ et 10¹⁷ atomes/cm³. Les régions de canal ont un niveau de dopage par exemple compris entre 2.10¹⁶ et 10¹⁸ atomes/cm³. Par ailleurs, les tranchées sont séparées de distances par exemple comprises entre 0,5 µm et 3,0 µm. Les tranchées pénètrent dans le substrat jusqu'à un niveau situé par exemple entre 0,5 µm et 8 µm en dessous du niveau inférieur des régions de canal.

Les figures 2A à 2F illustrent des étapes successives d'un mode de mise en oeuvre d'un procédé de fabrication d'une variante d'une structure 30 de la figure 1, reprenant de mêmes éléments que la structure 30 de la figure 1.

A l'étape de la figure 2A, on grave la tranchée 22 dans le substrat 20. Pour cela, à titre d'exemple, on recouvre le substrat d'une couche de masquage non représentée, par exemple en oxyde de silicium. On réalise, par exemple par lithographie, une ouverture dans la couche de masquage au-dessus de l'emplacement de la future tranchée, puis on procède à la gravure de la tranchée. On retire ensuite la couche de masquage.

Après cela, on forme une couche 308 de manière conforme, par exemple par oxydation thermique des parois de la tranchée et/ou par dépôt d'une couche d'oxyde de silicium. La couche 308 recouvre les parois de la tranchée. La couche 308 peut aussi recouvrir le substrat 20 en dehors des tranchées. L'épaisseur de la couche 308 est inférieure à la moitié de la largeur de la tranchée, de sorte qu'une ouverture 500 est conservée au centre de la tranchée.

A l'étape de la figure 2B, on remplit l'ouverture 500 du matériau conducteur de la région 306, par exemple jusqu'au niveau supérieur du substrat ou jusqu'à un niveau proche du niveau supérieur du substrat. Pour cela, ou procède par exemple à un dépôt conforme de silicium polycristallin dopé. On grave ensuite le silicium polycristallin jusqu'au niveau souhaité. On obtient ainsi la région 306.

A l'étape de la figure 2C, on grave la couche 308 à partir de la face supérieure jusqu'au niveau inférieur des futures régions 302. A titre d'exemple, la gravure est réalisée chimiquement. On obtient des cavités 502 en partie supérieure de la tranchée, de part et d'autre de la région 306.

A l'étape de la figure 2D, on forme la couche 304. Pour cela, à titre d'exemple, on oxyde thermiquement les parties des parois de la tranchée et de la région 306 qui ont été rendues accessibles à l'étape de la figure 2C. La couche 304 d'oxyde thermique ainsi formée sur les parois des cavités 502 peut se prolonger sur les surfaces supérieures du substrat et de la région 306.

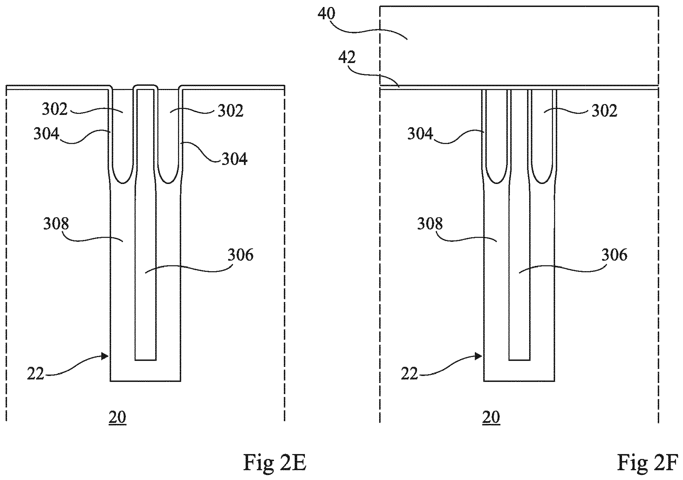

A l'étape de la figure 2E, on remplit les cavités 502, par exemple jusqu'au niveau supérieur du substrat ou jusqu'à un niveau proche du niveau supérieur du substrat. Pour cela, ou procède par exemple à un dépôt conforme de silicium polycristallin dopé. On grave ensuite le silicium polycristallin jusqu'au niveau souhaité. On obtient ainsi deux régions 302 de part et d'autre de la région 306.

A l'étape de la figure 2F, on retire les éventuels éléments situés sur la surface supérieure du substrat et des régions 302 et 306, tels que les portions accessibles de la couche 304. On forme ensuite l'éventuelle couche 42 et la couche 40.

La variante de la structure 30 obtenue par le procédé des figures 2A à 2F diffère de la structure 30 de la figure 1 en ce que la région 306 est disjointe de la région 302 et se prolonge jusqu'à la couche 40 ou l'éventuelle couche 42, et en ce que cette variante comprend deux régions 302 de part et d'autre de la région 306. Chaque région 302 est en contact électrique avec la couche 40. Chaque région 302 est séparée du substrat par une couche 304.

Une structure 30A peut être obtenue par un procédé similaire au procédé des figures 2A à 2F, dans lequel on prévoit en outre, entre les étapes des figures 2B et 2C, de former une couche de masquage protégeant la couche 308 située sur une paroi d'un seul côté de la tranchée 22, et de laisser libre la couche 308 de l'autre côté de la tranchée. On obtient une seule cavité 502 à l'étape de la figure 2C.

Des modes de réalisation particuliers ont été décrits. Diverses variantes et modifications apparaîtront à l'homme de l'art. En particulier, les structures 30 et 30A et leurs variantes peuvent être utilisées dans tout composant électronique utilisant l'influence électrostatique d'une région conductrice sur un substrat à travers une couche d'isolant, par exemple un transistor. En outre, on pourra prévoir une seule tranchée, avec par exemple un transistor au moins d'un côté.

De plus, dans les modes de réalisation décrits, on peut inverser les types de conduction N et P, donc les types N et P de canaux des transistors et la cathode et l'anode des diodes.

Divers modes de réalisation avec diverses variantes ont été décrits ci-dessus. On notera que l'homme de l'art pourra combiner divers éléments de ces divers modes de réalisation et variantes.

Enfin, la mise en oeuvre pratique des modes de réalisation décrits est à la portée de l'homme du métier à partir des indications fonctionnelles données ci-dessus.

## Revendications

1. Structure comprenant, dans une tranchée (22) d'un substrat (20), une première région conductrice (302) séparée du substrat d'une première distance (d) inférieure à environ 10 nm ; et une deuxième région conductrice (306) s'étendant plus profondément que la première région, les première et deuxième régions formant une région commune.

2. Structure selon la revendication 1, dans laquelle la deuxième région (306) est séparée du substrat (20) d'une deuxième distance supérieure à la première distance.

3. Structure selon la revendication 1 ou 2, dans laquelle la première région (302) est séparée du substrat par une première couche diélectrique (304) et la deuxième région (306) est séparée du substrat par une deuxième couche diélectrique (308).

4. Structure selon l'une quelconque des revendications 1 à 3, dans laquelle le substrat (20) est semiconducteur.

5. Structure selon la revendication 4, comprenant une portion de couche conductrice (40) recouvrant le substrat (20) et la tranchée (22), ladite portion étant connectée électriquement au substrat et aux première (302) et deuxième (306) régions.

6. Structure selon la revendication 5, dans laquelle ladite portion est en contact avec le substrat (20) ou séparée du substrat de moins de 300 nm.

7. Diode comprenant une ou plusieurs structures selon l'une quelconque des revendications 1 à 6.

8. Diode selon la revendication 7, définie par un ou plusieurs transistors dont au moins une région de canal (202) s'étend entre deux des tranchées (22), les premières régions (302) définissant les grilles des transistors.

9. Diode selon la revendication 8, comprenant une région de prise de contact (204) reliant électriquement la région de canal (202) à la couche conductrice (40).

10. Diode selon la revendication 8 ou 9, dans laquelle les premières régions (302) sont en un semiconducteur dopé, la région de canal (202) et les premières régions étant dopées de types de conductivité opposés.

11. Diode selon l'une quelconque des revendications 8 à 10, comprenant une région de drain (206) s'étendant sous la région de canal (202) entre les deux tranchées (22), et de préférence sous les tranchées.

12. Diode selon la revendication 11, dans laquelle la région de drain (206) est moins fortement dopée que la région de canal (202).

13. Procédé de fabrication d'une structure selon l'une quelconque des revendications 1 à 6.

14. Procédé selon la revendication 13 dans son rattachement à la revendication 3, comprenant la formation de la deuxième couche diélectrique (308) sur les parois et le fond de la tranchée (22), et le retrait d'une partie de la deuxième couche diélectrique située à l'emplacement (502) de la future première région (302).

15. Procédé selon la revendication 14, comprenant une étape d'oxydation thermique de parois de la tranchée délimitant l'emplacement (502) de la future première région (302).
